Europäisches Patentamt

European Patent Office

Office européen des brevets

(19)

(11) Veröffentlichungsnummer: **0 105 505**
**A1**

(12) **EUROPÄISCHE PATENTANMELDUNG**

(21) Anmeldenummer: **83109836.3**

(22) Anmeldetag: **01.10.83**

(51) Int. Cl.³: **G 01 R 31/36**

(30) Priorität: **05.10.82 CH 5853/82**

(43) Veröffentlichungstag der Anmeldung:
**18.04.84 Patentblatt 84/16**

(84) Benannte Vertragsstaaten:
**AT BE CH DE FR GB IT LI LU NL SE**

(71) Anmelder: **Eberhart, Walter**
**Landvogt Waser Strasse 33**
**CH-8405 Winterthur(CH)**

(72) Erfinder: **Eberhart, Walter**
**Landvogt Waser Strasse 33**
**CH-8405 Winterthur(CH)**

(74) Vertreter: **Frei, Alexandra Sarah**
**Egli Patentanwälte Horneggstrasse 4**
**CH-8008 Zürich(CH)**

(54) **Batterietestvorrichtung ohne Messkabel zur raschen Überprüfung des Zustandes einer Trockenbatterie.**

(57) Die Vorrichtung (1) weist ein zylindrisches Gehäuse (4) mit darin eingebauter Auswertelektronik (10) auf. Die eine Seite des zylindrischen Gehäuses (4) ist mit einer Frontplatte (2) abgedeckt, auf der Anzeigeelemente (7) und eine Bewertungsskala angeordnet sind. Die andere Seite ist offen und dient zum Aufstülpen der Vorrichtung auf eine Batterie. In bestimmter Gehäusetiefe sind die Messkontakte (17, 18), ein Mittenkontakt (18) und ein Ringkontakt (19) angeordnet.

FIG. 3

EP 0 105 505 A1

Croydon Printing Company Ltd.

- 1 -

Batterietestvorrichtung ohne Messkabel zur raschen Ueberprüfung des Zustandes einer Trockenbatterie

Die Erfindung betrifft eine Vorrichtung zum Messen der Spannung an einer Batterie mit in einem Gehäuse angeordneten
elektrischen Schaltelementen zur Auswertung der von der
Batterie abgegebenen Spannung und mit einer Anzeigeeinrichtung zur Anzeige des gemessenen Spannungswertes.

Das Prüfen des Zustandes einer Batterie ist mit mannigfachen Mitteln möglich; Aussagen bezüglich des Ladungszustandes bzw. der verbliebenen Restenergie erfordern schon differenziertere Mittel, insbesondere ist hier die Spannungsmessung im Belastungszustand zu nennen. Die Messung der Spannung unter geeigneter Ohm'scher Belastung und die Angabe
der gemessenen Spannung, auch wenn es nur eine grobquantitative Angabe ist, erfordert einen gewissen Schaltungsaufwand. Geräte, die diesen Schaltungsaufwand in sich bergen,
sind bekannt.

Geräte dieser Art sind mit zwei oder nur einem Messkabel
versehen, mit denen die Kontakte der zu messenden Batterie
berührt werden; eine Anzeige zeigt dann den Ladungszustand
an. Das Vorgehen zur Messung ist oft vom Batterietyp abhängig, und zwar davon, wie und wo die Batteriekontakte
zugänglich oder abgreifbar sind.

Von der Tradition der Messgerätetechnik her haben sich Batterietester mit zwei Messkabeln am meisten verbreitet. Die Polarität ist dabei durch einen Farbcode angegeben; eine
Messung mit evtl. falscher Polarität hat keine Folgen,
es müssen lediglich die Kontakte vertauscht werden.

Weiteste Verbreitung haben inzwischen die 6V-Batterien erfahren, die bspw. unter der Bezeichnung ICE 4 R 25 bekanntgeworden sind und die beispielsweise in Baulampen in grosser
Zahl verwendet werden. Dies um nur eine der vielseitigen
Massenanwendungen dieses erfolgreichen Batterietyps anzugeben. Gerade diese Verbreitung bringt es mit sich, dass auch
technisch ungenügend instruierte Personen in die Lage kommen, solche Batterien testen zu müssen, wobei dieselben
Personen auch die Triage bei den von ihnen geprüften Batterien durchführen müssen. Es ist daher von Interesse, Fehlbedienungen bei der Messung möglichst auszuschliessen, um
beispielsweise gerade bei Baustellen-Markierlampen aus Sicherheitsgründen ein Funktionieren der Lichtleistung während der Dunkelzeit zu garantieren oder bspw. zu vermeiden,
dass Batterien mit noch brauchbarer Ladung weggeworfen werden.

Bei diesen Anwendungen konnten die bisher bekannten Testgeräte nicht befriedigen. Einerseits ist oft die verlangte
Robustheit nicht vorhanden. Andrerseits zeigte sich eine
Zweihand-Bedienung mit Messkabeln als umständlich, oft werden nach Verlust der Messkabel diese durch Drähte aller
Art einfach ersetzt, was weiter zu Fehlmessungen führte.
Nicht zuletzt werden solche Geräte mangels Bedienungsfreundlichkeit gar nicht mehr benutzt und die Batterien
überhaupt nicht geprüft - die vollständige Entladung der
Batterie wird festgestellt, wenn die Lampe nicht mehr
funktioniert. Dies bedeutet nicht selten ein erheblich
hohes Sicherheitsrisiko.

Es ist daher das Ziel der Erfindung, eine Vorrichtung zum Testen von Batterien zu schaffen, mit welcher der Ladezustand einer Batterie ohne die Möglichkeit einer Fehlbedienung einfach und sicher ermittelt werden kann. Es soll beim Messen keine Erwägung der Kontaktabnahme, der Polarität und der Manipulation mit Messkabeln nötig sein.

Ein weiteres Ziel der Erfindung ist es, dass auch ein spezielles Ausrichten und Positionieren der Vorrichtung zu den Batteriekontakten entfallen soll und gleichzeitig eine echte Einhandbedienung gewährleistet ist.

Diese Ziele werden erfindungsgemäss erreicht durch in die Messvorrichtung integrierte Messkontakte, die durch Aufsetzen der Vorrichtung auf die Batterie mit deren Kontakten direkt in Berührung kommen.

In der Weiterausbildung der Erfindung ist ein Teil des Gehäuses der Vorrichtung über die zu messende Batterie stülpbar und die integrierten Messkontakte in einer beschränkten Gehäusetiefe angeordnet.

Weiterausgebildet ist die Erfindung durch eine zylindrische Formgebung des Gehäuses, und dass die in einer bestimmten Gehäusetiefe sich befindenden Messkontakte konzentrisch zueinander angeordnet sind, wobei ein Mittenkontakt von einem Ringkontakt umgeben ist und beide Kontakte entsprechend dem Batteriekontaktabstand voneinander beabstandet sind.

Vorteilhafter werden die Messkontakte als Leiterbahnen einer gedruckten Schaltung ausgeführt.

Die Erfindung wird nun anhand der nachfolgend aufgeführten
Figuren im Detail dargelegt. Es zeigen:

Figur 1 den erfindungsgemässen Batterietester im Zusammenhang mit einer 6V-Batterie,

Figur 2a, b, c eine Draufsicht, einen Längsschnitt und die
untere Ansicht der Vorrichtung gemäss Erfindung,

Figur 3 im Längsschnitt die auf eine Batterie aufgesteckte
Messvorrichtung.

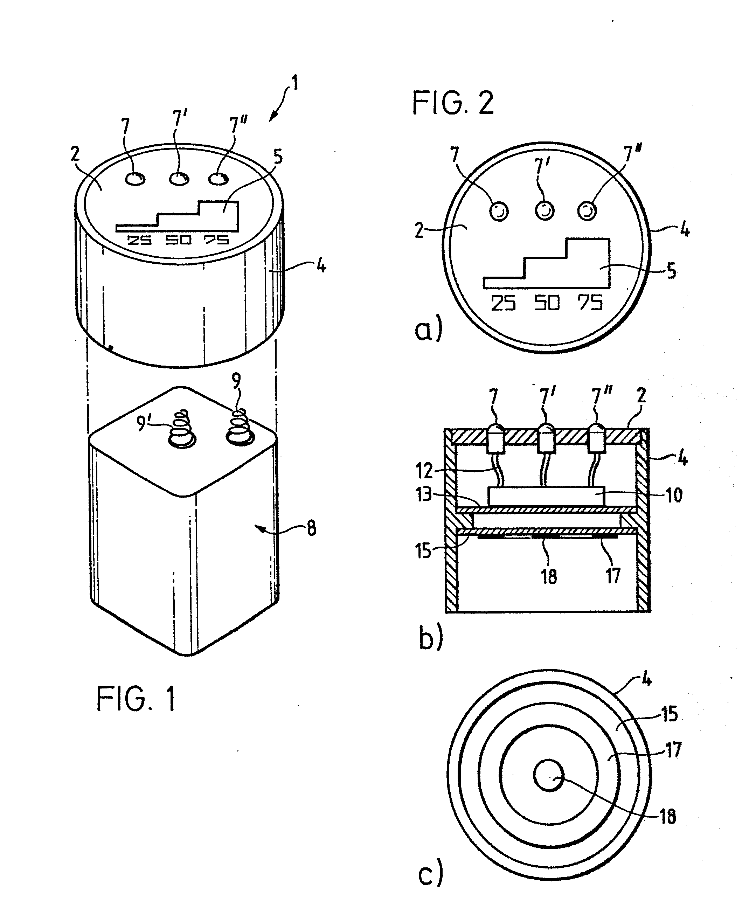

Die eingangs erwähnten sehr verbreiteten 6V-Batterien weisen eine quaderförmige bzw. prismatische Form mit abgerundeten Längskanten auf. Die beiden Stromabnehmer sind auf
einer Stirnseite angeordnet und bestehen üblicherweise
aus einem zu einer kegelförmigen Spirale gedrehten Kontaktdraht. Diese der Schrauben-Druck- oder Zugfeder angenäherte
Formgebung soll den nötigen Kontaktdruck auch bei leichten
Dislokationen des Batteriekörpers herbeiführen. Einer der
beiden Stromabnehmer ist im Zentrum der Stirnfläche, der
zweite auf einer durch das Zentrum verlaufenden Diagonale
nahe an einer der vier Ecken der Stirnfläche angeordnet.
Solch eine Batterie ist in Figur 1 mit der Bezugsziffer 8
abgebildet; die beiden Batteriekontakte sind mit 9' für
den Mittenkontakt und 9 für den Eckkontakt bezeichnet. In
räumlicher Darstellung darübergezeichnet ist die Vorrichtung zum Messen der Spannung an einer Batterie gemäss Erfindung.

Diese Vorrichtung besteht in letztlicher Ausgestaltung
aus einem zylinderförmigen Gehäuse 4, in dessen Innern

- 5 -

eine elektronische Auswerteschaltung angeordnet ist. Unten ist die Vorrichtung bis zu einer bestimmten Gehäusetiefe offen, oben ist sie mit einer Frontplatte abgedeckt, auf welcher eine Bewertungsskala 5 zur Bewertung der Anzeigeeinrichtung 7, 7', 7" angebracht ist. In diesem Beispiel ist die Anzeigeeinrichtung eine Anordnung von 3 Dioden zur bspw. Anzeige eines Ladestandes von 25% bis 50%, von 50% bis 75% und von 75% und darüber. Selbstverständlich sind auch andere Bewertungen wie schlecht, mittel, gut möglich. Feinere Unterteilungen hätten eine grössere Anzahl Dioden zur Folge, oder aber eine andere Art von Anzeige wird dieser vorgezogen. Aus Gründen der Erlangung einer möglichst hohen Robustheit sind zum Beispiel Zeigerinstrumente eher ungeeignet.

Wie dies aus Figur 1 ersichtlich ist, lässt sich der Batterietester lose über die Batterie stülpen, also nicht im Sinne eines Zusammensteckens, das dann einen gegenseitigen Halt bewirken würde. Die Vorrichtung gemäss Erfindung ist so ausgestaltet, dass sie sich zwanglos über die Batterie stülpen lässt, wobei die Dimension so gewählt wird, dass die Batterie um ungefähr einen Drittel ihrer Gesamthöhe vom Gehäuse der Vorrichtung überdeckt wird. Das Auflegen auf die Batterie und das Abnehmen von der Batterie muss ohne Klemmen gewährleistet sein.

Die Anordnung der Messkontakte im Innern der Vorrichtung sowie ein beispielsweiser Aufbau des ganzen Gerätes ist in den Figuren 2a, b und c gezeigt. Man erkennt in Figur 2a das Testgerät von oben gesehen; die sichtbare Frontplatte wurde schon im Zusammenhang mit Figur 1 beschrieben. In einer Schnittdarstellung ist die Vorrichtung in

Figur 2b gezeigt. Die Frontplatte 2 hält die drei Leuchtdioden 7, 7', 7", welche ihrerseits über die Anschlussdrähte 12 mit einer bekannten Auswerteschaltung 10 verbunden sind. Diese Auswerteschaltung 10 ist bspw. auf
einer Printplatte 13 angeordnet, welche im zylinderförmigen Gehäuse 4 befestigt ist. Weiterhin ist im Gehäuse 4
befestigt eine Trägerplatte 15 für die Messkontakte 17
und 18, die im Gerät fest angeordnet sich in einer bestimmten Gehäusetiefe befinden. Die ganz spezielle Anordnung der Messkontakte ist in der Ansicht von unten gemäss
Figur 2c gezeigt.

Diese Messkontakte 17 und 18 sind zueinander konzentrisch
angeordnet, vorzugsweise in der Form eines Mittenkontaktes
18 als Messkontakt zum zentralen Stromabnehmer 9' der
Batterie und in Form eines Ringkontaktes 17 als Messkontakt zum eckständigen Stromabnehmer 9 der Batterie. Der
Abstand der Messkontakte bspw. die Radiusdifferenz entspricht im wesentlichen dem Abstand der beiden Stromabnehmer zueinander. Die Ausbildung des einen Messkontaktes zu
einem Ringkontakt 17 erlaubt erstens das beliebige Aufsetzen des Messgerätes auf die Batterie, ohne eine Ausrichtung der Kontakte beachten zu müssen, und zweitens
eine Drehung des Messgerätes um einen beliebigen Winkel
zum bspw. Ablesen der Anzeigeeinrichtung. Durch die in jedem Sinne symmetrische Ausgestaltung vom Gehäuse der Vorrichtung und den darin angeordneten Messkontakten ist eine
echte Einhandbedienung gewährleistet. Das Gerät kann in
dieser Form recht robust ausgestaltet werden.

Die Messkontakte können je nach vorgesehener Lebensdauer
und nicht zuletzt zur Preisgestaltung entweder als massive Körper auf einer Unterlage befestigt ausgebildet sein oder
als Leiterbahnen auf einer Printplatte integriert werden,
wobei die Kontaktflächen galvanisch mit einem harten Ueberzug versehen sind.

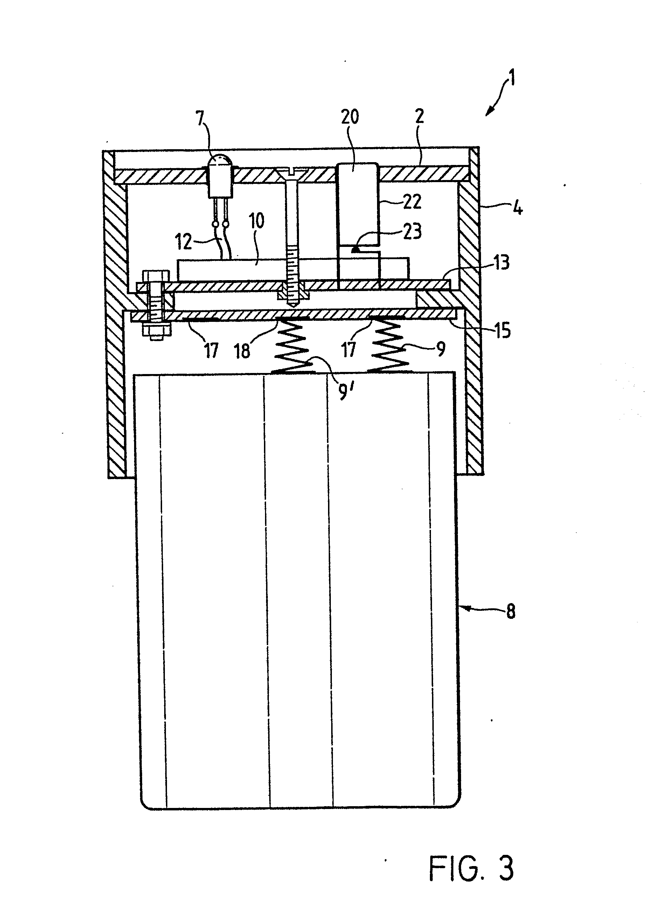

Figur 3 zeigt die Vorrichtung in einer erweiterten Ausführungsform in Messposition zur Batterie. Die Erweiterung besteht in einer Einrichtung 20 zum Testen von Glühlampen,
wie sie im Zusammenhang mit den genannten 4R25-Batterien
verwendet werden. Die Einrichtung 20 ist in die Frontplatte
2 integriert und weist zwei Kontakte 22 und 23 auf, die mit
den Messkontakten 17 und 18 in Verbindung stehen. Neben der
Prüfung der Batterie ist bei einem Defekt der Leuchte gleich
noch die darin arbeitende Lampe kontrollierbar, wobei die
zu testende Batterie den Strom zur Glühlampenkontrolle liefert.

P a t e n t a n s p r ü c h e

---

1. Vorrichtung zum Messen der Spannung an einer Batterie
   mit in einem Gehäuse angeordneten elektrischen Schaltelementen zur Auswertung der von der Batterie abgegebenen Spannung und mit einer Anzeigeeinrichtung zur Anzeige des gemessenen Spannungswertes, gekennzeichnet
   durch in der Vorrichtung integrierte Messkontakte, die
   durch Aufsetzen der Vorrichtung auf die Batterie mit
   deren Kontakten direkt in Berührung kommen, wobei ein Teil des Gehäuses der Vorrichtung über die zu
   messende Batterie stülpbar ist und die Messkontakte in
   einer bestimmten Gehäusetiefe angeordnet sind.

2. Vorrichtung nach Anspruch 1, dadurch gekennzeichnet,
   dass das Gehäuse der Vorrichtung zylindrisch ist und
   die in einer bestimmten Gehäusetiefe sich befindenden
   Messkontakte konzentrisch zueinander angeordnet sind.

3. Vorrichtung nach Anspruch 2, dadurch gekennzeichnet,
   dass die konzentrischen Messkontakte aus einem Ringkontakt und einem Mitten-Kontakt bestehen, die entsprechend dem Batterie-Kontaktabstand voneinander beabstandet sind.

4. Vorrichtung nach den Ansprüchen 2, oder 3, dadurch gekennzeichnet, dass die Messkontakte als Leiterbahnen einer gedruckten Schaltung ausgeführt sind.

5. Vorrichtung nach einem der Ansprüche 1 bis 4, dadurch gekennezeichnet, dass die Frontplatte (2) eine Einrichtung (20) zum Testen einer Lampe mit Kontakten (20, 23) integriert enthält.

FIG. 2

7   7'   7"

2

5

4

25   50   75

1

2

5

4

25   50   75

a)

9'   9

8

7   7'   7"   2

4

12

13

10

15

18   17

b)

4

15

17

18

c)

FIG. 1

FIG. 3

**0105505**

Nummer der Anmeldung

## Europäisches Patentamt

## EUROPÄISCHER RECHERCHENBERICHT

EP 83 10 9836

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | GB-A-2 060 181 (FISHER-KARPARK INDUSTRIES LTD.) <br> * Figur 1; Seite 1, Zeilen 69-75 * | 1 | G 01 R 31/36 |
| | --- | | |
| A | DE-A-2 146 050 (INTERTON-ELECTRONIC) <br> * Figur 1; Anspruch 1 * | 1 | |
| | --- | | |
| A | DE-A-1 671 712 (BANDELIN ELECTRONIC) <br> * Figur 1 * | 1 | |
| | --- | | |
| A | US-A-1 337 160 (G.H. RIEBETH) <br> * Figur 2 * | 1 | |
| | ----- | | |

RECHERCHIERTE SACHGEBIETE (Int. Cl. ³)

G 01 R
H 01 M

Der vorliegende Recherchenbericht wurde für alle Patentansprüche erstellt.

| Recherchenort | Abschlußdatum der Recherche | Prüfer |
|---|---|---|
| DEN HAAG | 03-01-1984 | MIELKE W |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82